Europäisches Patentamt

European Patent Office

Office européen des brevets

(19)

(11) EP 0 556 201 B1

(12) **EUROPÄISCHE PATENTSCHRIFT**

(45) Veröffentlichungstag und Bekanntmachung des Hinweises auf die Patenterteilung:
**15.05.1996 Patentblatt 1996/20**

(21) Anmeldenummer: **91917897.0**

(22) Anmeldetag: **23.10.1991**

(51) Int Cl.6: **H01L 29/10**

(86) Internationale Anmeldenummer:
**PCT/DE91/00825**

(87) Internationale Veröffentlichungsnummer:
**WO 92/09107 (29.05.1992 Gazette 1992/12)**

(54) **Halbleiterbauelement mit einer Spannungsbegrenzungszone**

Semiconductor device with a voltage-limiting region

Dispositif semi-conducteur comportant une région limiteuse de tension

(84) Benannte Vertragsstaaten:
**DE FR GB IT**

(30) Priorität: **08.11.1990 DE 4035500**

(43) Veröffentlichungstag der Anmeldung:
**25.08.1993 Patentblatt 1993/34**

(73) Patentinhaber: **ROBERT BOSCH GMBH**
**70442 Stuttgart (DE)**

(72) Erfinder:
- **PLUNTKE, Christian**
  **D-7450 Hechingen (DE)**
- **GOERLACH, Alfred**
  **D-7408 Kusterdingen (DE)**

(56) Entgegenhaltungen:
**DE-A- 1 439 481**

- **S. M. Sze, "Physics of Semiconductor Device,**
  **Second Edition" (J. Wiley & Sons, New York,**
  **1981), Seite 73**

# Beschreibung

## Stand der Technik

Die Erfindung geht aus von einer Halbleiteranordnung insbesondere einem elektronischen Schalter nach der Gattung des Hauptanspruchs. Elektronische Schalter wie zum Beispiel Transistoren und Dioden, die auf Halbleiterbasis aufgebaut sind, sind bekannt. Soll beispielsweise ein bipolarer Transistor in Emitterschaltung bei hohen Stromdichten im Avalanche-Durchbruch betrieben werden, ist es meist günstiger, wenn die Durchbruchsspannung zwischen Kollektor und Emitter bei offener Basis wegen der Gefahr einer Zerstörung durch den zweiten Durchbruch, dem sogenannten Reverse Second Break-down, nicht erreicht wird. Zur Spannungsbegrenzung kann hier, wie auch bei sonstigen Schaltungen mit elektronischen Schaltern, eine Zenerdiode mit oder ohne Spannungsteiler eingesetzt werden. Die Spannungsbegrenzungsschaltung kann extern an den elektronischen Schalter angeschlossen sein oder in den Halbleiter des Schalters integriert werden. Die externe Beschaltung bedeutet einen zusätzlichen Herstellungsaufwand, überdies vergrößert sich der Platzbedarf der Gesamtschaltung. Die Integration der Spannungsbegrenzungsschaltung in den Halbleiter des elektronischen Schalters beispielsweise mittels Planartechnik bedeutet ebenfalls, daß der Herstellungsprozeß für den elektrischen Schalter durch die zusätzlichen Bauelemente der Begrenzungsschaltung aufwendiger wird.

## Vorteile der Erfindung

Die erfindungsgemäße Halbleiteranordnung mit den im Hauptanspruch genannten Merkmalen hat demgegenüber den Vorteil, daß die Anordnung zur Begrenzung der Durchbruchs spannung in den Halbleiter des elektronischen Schalters integriert werden kann, ohne daß der Herstellungsprozeß geändert werden muß. Dadurch erhöhen sich Aufwand und Kosten für die Herstellung des spannungsgeschützten elektronischen Schalters praktisch nicht; eine Zusatzbeschaltung zur Spannungsbegrenzung kann entfallen.

Bei der erfindungsgemäßen Halbleiteranordnung ist die Spannungsbegrenzungszone in einem Randbereich der Grenzschicht angeordnet, der etwa senkrecht auf der die Grenzschicht schneidenden Oberfläche des Halbleiters steht. Das heißt, die Grundfläche einer in das Substrat des Schalters eingebrachten Dotierungsschicht bleibt unverändert. Damit beeinträchtigt die Spannungsbegrenzungszone das Schaltverhalten der Halbleiteranordnung grundsätzlich nicht.

Bei einem bevorzugten Ausführungsbeispiel wird eine Spannungsbegrenzungszone vorgesehen, die sich dadurch auszeichnet, daß mehrere unmittelbar aufeinandergrenzende, abwechselnd konkav und konvex gewölbte, vorzugsweise praktisch halbkreisförmig ausgebildete Bereiche am Rand der Grenzschicht bzw. des pn-Übergangs einer Diffusionsschicht vorgesehen sind. Bei einer derartigen Ausgestaltung der Spannungsbegrenzungszone werden zu hohe lokale Stromdichten vermieden, die zu einer zu starken Erwärmung des Bauelements führen könnten. Überdies ergibt sich eine relativ scharfe Durchbruchskennlinie, das heißt, die Durchbruchsspannung ist stromunabhängig.

Bevorzugt wird weiterhin ein Ausführungsbeispiel, bei dem die Spannungsbegrenzungszone mehrere gewölbte, vorzugsweise im wesentlichen halbkreisförmig ausgebildete Bereiche aufweist, die durch gerade Abschnitte verbunden sind. Auch durch diese Ausgestaltung der Grenzschicht bzw. des pn-Übergangsbereichs kann ein genau definiertes Durchbruchsverhalten eingestellt werden, wobei auch die Durchbruchskennlinie auf den gewünschten Anwendungsfall abgestimmt werden kann.

Weitere vorteilhafte Ausgestaltungen und Verbesserungen der erfindungsgemäßen Halbleiteranordnung ergeben sich aus den übrigen Unteransprüchen.

## Zeichnung

Die Erfindung wird im folgenden anhand der zwei Ausführungsbeispiele wiedergebenden Zeichnung näher erläutert. Es zeigen:

Figur 1 einen schematischen Querschnitt durch eine als planarer vertikaler Leistungstransistor ausgebildete Halbleiteranordnung;

Figur 2 eine schematische Draufsicht auf den elektronischen Schalter gemäß Figur 1;

Figur 3 ein Diagramm zur Darstellung der Abhängigkeit der Durchbruchsspannung $U_{BR}$ vom Krümmungsradius R;

Figur 4 eine vergrößerte Darstellung des pn-Übergangs des elektronischen Schalters gemäß den Figuren 1 und 2 und

Figur 5 eine vergrößerte Darstellung des pn-Übergangs eines weiteren Ausführungsbeispiels des elektronischen Schalters.

## Beschreibung der Erfindung

Die Erfindung wird im folgenden beispielhaft anhand eines Transistors erläutert. Die erfindungsgemäße Spannungsbegrenzung ist jedoch für elektronische Schalter aller Art, beispielsweise auch für Dioden, Thyristoren, Darlingtontransistoren, Zündtransistoren anwendbar. Sie ist sowohl für npn- als auch für pnp-Transistoren einsetzbar.

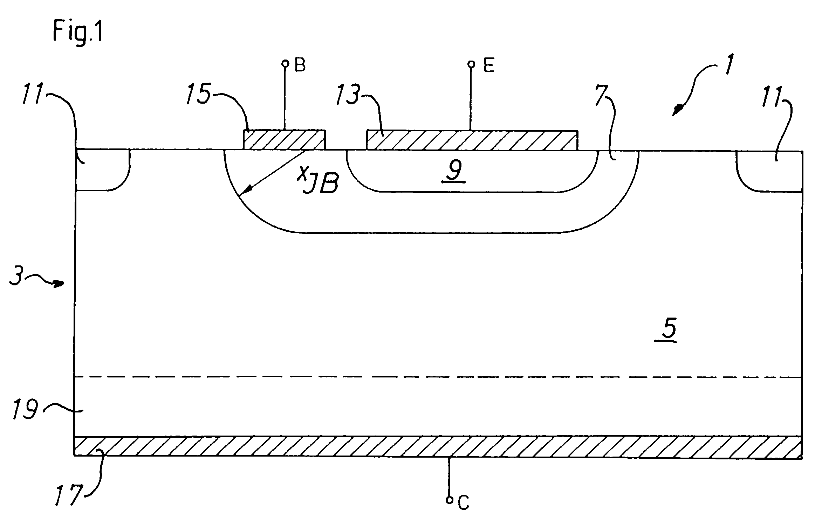

Figur 1 zeigt schematisch einen planaren npn-Leistungstransistor im Schnitt. Zur verbesserten Übersichtlichkeit der Darstellung sind hier Oxidschichten nicht eingezeichnet.

Der Transistor 1 weist einen Halbleiter 3 mit Bereichen verschiedener Dotierung auf. In eine hochohmige $n^-$-Kollektorschicht 5 ist eine erste Diffusionsschicht, hier eine p-dotierte Basiswanne 7 eingebracht. Die Dotierung erstreckt sich bis zu einer Tiefe $x_{JB}$. In die Basiswanne 7 ist eine weitere Schicht eindiffundiert; es handelt sich hier um eine $n^+$-dotierte Schicht, die als Emitter 9 dient. In einem Abstand zur Basiswanne 7 sind in die Oberfläche des Halbleiters 3 weitere $n^+$-dotierte Schichten durch Diffusion eingebracht, die als Channelstopper 11 dienen.

Auf die $n^+$-dotierte Schicht des Emitters 9 ist ein erster leitender, vorzugsweise metallischer Kontakt 13 aufgedampft, der elektrisch leitend mit einem Emitter-Anschluß E verbunden ist. Ebenfalls auf der Oberseite des Halbleiters ist im Bereich der Basiswanne 7 ein zweiter metallischer Kontakt 15 aufgebracht, beispielsweise aufgedampft, der elektrisch leitend mit einem Basisanschluß B verbunden ist.

Auf der dem Emitteranschluß E bzw. Basisanschluß B gegenüberliegenden Seite des Substrats bzw. Halbleiters 3 ist eine Metallschicht 17 aufgebracht, die elektrisch leitend mit einem Kollektoranschluß C verbunden ist. Im Bereich der Metallschicht 17 weist der Substratkörper eine Schicht 19 auf, die niederohmiger ist als die übrige Kollektorschicht 7.

Zwischen den Bereichen verschiedener Dotierungen ergeben sich Grenzschichten, deren Verlauf in Figur 1 mit Linien dargestellt sind. Aus der Darstellung ist ersichtlich, daß die die Grundflächen der in das Substrat 3 eindiffundierten Schichten bildenden Grenzschichten, also quasi die Unterseite der Basiswanne 7 bzw. der $n^+$-dotierten Schicht des Emitters 9 eben ausgebildet sind und im wesentlichen parallel zur Oberseite des Transistors 1 verlaufen. In den Randbereichen der dotierten Schichten ergibt sich aufgrund des Diffusionsprozesses während der Herstellung der Schichten ein gekrümmter Bereich der Grenzschichten. Das heißt, die Seitenwände der Schichten verlaufen -ausgehend von der Grundfläche- nicht rechtwinklig sondern quasi zylindrisch. Der Übergangsbereich zwischen der Grundfläche der dotierten Schichten zur Oberfläche des Halbleiters verläuft also entlang der Mantelfläche eines Zylinders, dessen Radius der Tiefe $x_{JB}$ der dotierten Schicht entspricht. Schließlich schneidet die Grenzschicht die Oberfläche des Halbleiters 3 unter einem Winkel von ca 90°.

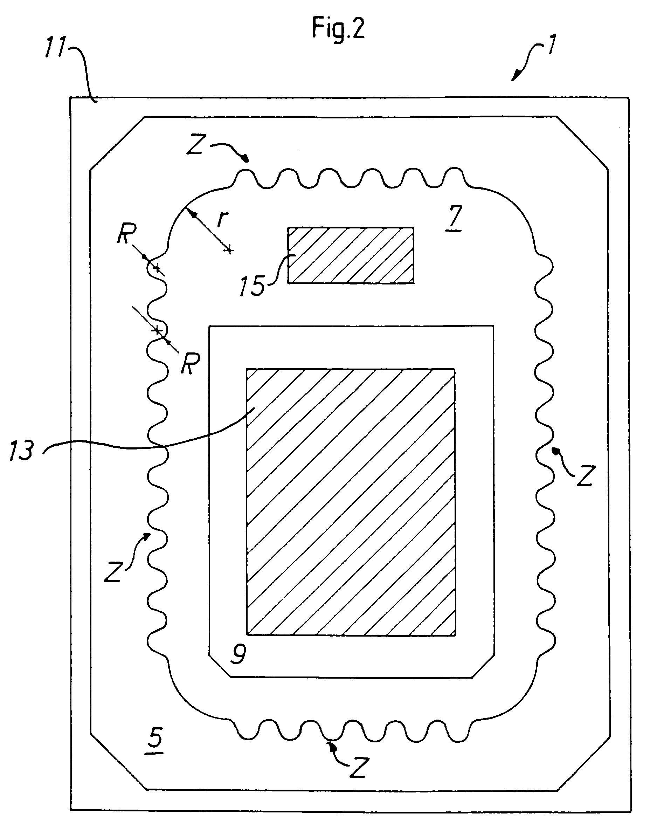

In der schematischen Draufsicht gemäß Figur 2 sind gleiche Teile des in Figur 1 dargestellten elektronischen Schalters bzw. Transistors 1 mit gleichen Bezugszeichen versehen. In sofern wird auf die dortige Beschreibung verwiesen.

Aus der Draufsicht ist ersichtlich, daß die Oberseite des Transistors 1 quasi von einem Rahmen umgeben wird, der durch die als Channelstopper 11 dienenden Diffusionsschicht gebildet wird. An diese $n^+$-dotierte Schicht schließt sich die $n^-$-dotierte Kollektorschicht 5 an. Der Übergangs- bzw. Randbereich bzw. Grenzschicht zwischen dieser Schicht und der sich anschließenden p-dotierten Basis 7, also der pn-Übergang des Transistors 1, ist zumindest bereichsweise nicht geradlinig ausgebildet. Insgesamt gesehen ist die Basiswanne im wesentlichen rechteckförmig, wobei im Bereich der Ecken eine Krümmung mit dem Radius r vorgesehene ist. Die Längs- und Querseiten der Basiswanne weisen mehrere, aneinander grenzende Bereiche auf, die hier kreisbogenförmig unter einem Krümmungsradius R gekrümmt sind, wobei sich konkave und konvexe Bereiche unmittelbar abwechseln. Diese gekrümmten Bereiche bilden Spannungsbegrenzungszonen Z. Es ist deutlich erkennbar, daß der Krümmungsradius R wesentlich kleiner ist als der Radius r in den Eckbereichen der Basiswanne.

Auf einen Bereich der Oberseite ist die als zweiter Kontakt 15 bezeichnete Metallfläche aufgedampft, an die der hier nicht dargestellte Basiskontakt B (siehe Figur 1) elektrisch leitend angeschlossen ist.

Innerhalb der Basiswanne 7 ist der hier ebenfalls im wesentlichen rechteckig ausgebildete Emitter 9 angeordnet, auf dessen Oberseite die als erster Kontakt 13 bezeichnete Metallfläche aufgedampft ist. Diese dient dem elektrischen Anschluß des ebenfalls nicht dargestellten Emitterkontakts E (siehe Figur 1).

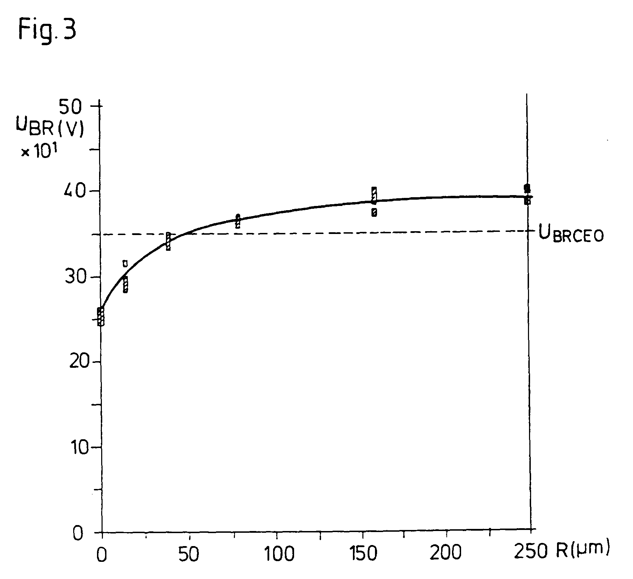

Aus Figur 3 ist ersichtlich, daß die Spannungsbegrenzung durch die Spannungsbegrenzungszone Z abhängig ist von dem Krümmungsradius R der einzelnen gekrümmten Bereiche. Aus dem Diagramm ist die Abhängigkeit der Begrenzungsspannung $U_{BR}$ (gemessen in Volt) von dem Krümmungsradius R (gemessen in $\mu$m) ersichtlich. Gestrichelt ist die Durchbruchsspannung $U_{BRCE0}$ zwischen Kollektor und Emitter bei offener Basis eingetragen.

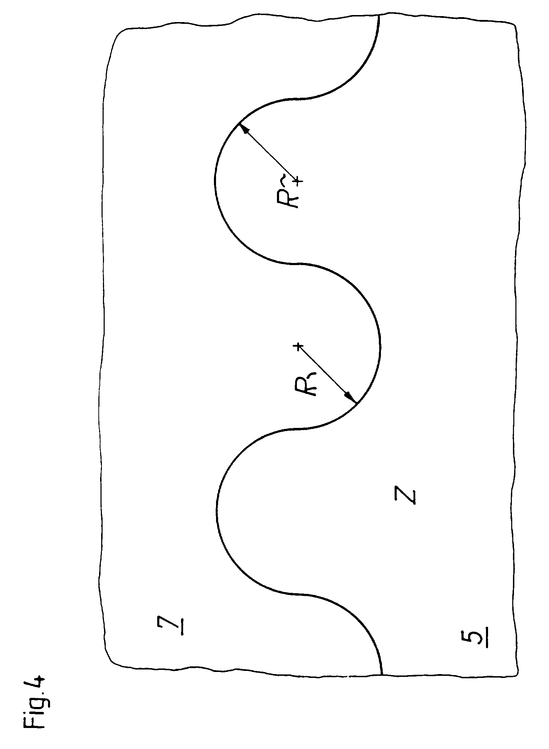

Figur 4 zeigt einen Ausschnitt eines Bereichs des pn-Übergangs bzw. des Randes zwischen Basis und Kollektor, der als Spannungsbegrenzungszone Z dient. Die Fläche mit der Bezugsziffer 5 stellt die hochohmige Kollektorschicht und die Fläche mit der Bezugsziffer 7 die Basis dar.

Aus der Darstellung ist ersichtlich, daß der Randbereich der Grenzschicht kreisbogenförmig gekrümmte Bereiche aufweist, deren Krümmungsradius mit R bezeichnet ist. Die einzelnen Bereiche schließen unmittelbar aneinander an, so daß die Randzone quasi mäanderförmig ausgebildet ist. Bei der hier dargestellten Ausführungsform grenzt ein konkav gewölbter Bereich der Spannungsbegrenzungszone unmittelbar an einen konvex gewölbten Bereich an.

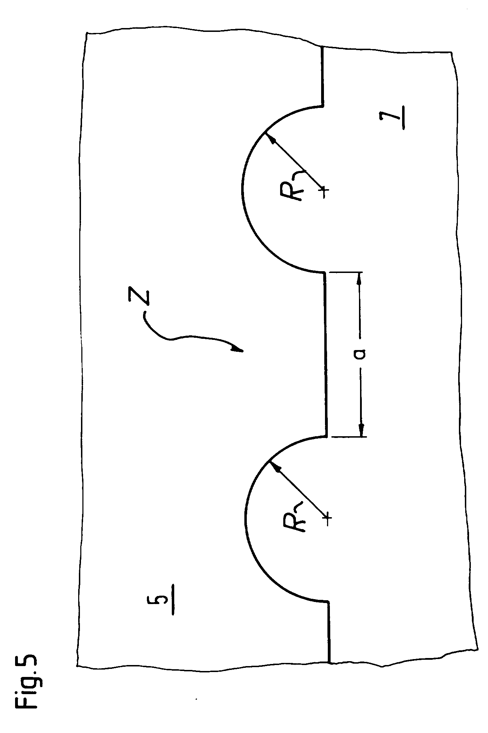

Figur 5 zeigt vergrößert ebenfalls den Randbereich der Grenzschicht zwischen Basis und Kollektor eines Transistors bzw. einen pn-Übergang. Es ist jedoch ersichtlich, daß sich bei dem hier dargestellten Ausführungsbeispiel gewölbte Bereiche mit geradlinigen Abschnitten abwechseln. Die gewölbten Bereiche weisen hier Kreisbogenform und einen Krümmungsradius R auf. Die Länge der geradlinigen Bereiche ist mit a bezeichnet.

Durch die anhand der Figuren erläuterte spezielle Ausgestaltung des pn-Übergangs im Randbereich der Grenzschicht zwischen Basis und Kollektor wird die maximal an dem als Transistor ausgebildeten elektronischen Schalter auftretende Spannung $U_{BR}$ zwischen Kollektor und Basis begrenzt. Dabei gilt, daß die Begrenzungsspannung $U_{BR}$ kleiner sein soll als die Durchbruchs spannung $U_{BRCEO}$ zwischen Kollektor und Emitter bei offener Basis. Es gilt also:

$$U_{BR} < U_{BRCEO}.$$

Am Transistor stellt sich eine Kollektor-Emitter-Spannung $U_{CEO}$ ein, für die folgende Beziehung gilt:

$$U_{CEO} = U_{BR} + U_{BE}$$

wobei mit $U_{BE}$ die Basis-Emitter-Flußspannung des Transistors bezeichnet wird.

Für die folgenden Betrachtungen wird unterstellt, daß die Grenzschicht bzw. der pn-Übergang einen großen Dotierungsgradienten aufweist, so daß der Basis-Kollektor-Übergang als einseitig abrupter pn-Übergang behandelt werden kann.

Durch die Ausbildung der aus Figur 1 ersichtlichen Diffusionsschicht, die als Basis 7 dient, ergeben sich im Randbereich der Grenzschicht zylindrische $pn^-$-Übergänge mit einem Zylinderradius von $x_{JB}$. In diesen Bereichen ist die Avalanche-Durchbruchsspannung geringer als bei ebenen pn-Übergängen, wie Sie beispielsweise bei unendlich ausgedehnten Diffusionsschichten gegeben sind (sogenannter unendlich ausgedehnter pn-Übergang).

Bezeichnet man mit W die Weite der Raumladungszone beim Durchbruch und mit $U_{BRCEO}$ die Durchbruchsspannung des Basis-Kollektor-Übergangs beim offenem Emitter, so gilt folgende Gleichung:

$$U_{BRCEO}^{ZYL} < U_{BRCBO}^{EBEN}.$$

Diese Gleichung gilt unter der Voraussetzung, daß die Dicke der Dotierungsschicht und damit der Radius $x_{JB}$ des zylindrisch gewölbten Randbereichs maximal so groß ist wie die Weite W der Raumladungszone. Also für den Fall, daß die Gleichung $x_{JB} \leq W$ gilt.

Die Durchbruchs spannung $U_{BRCEO}^{ZYL}$ nimmt bei abnehmendem Zylinderradius $x_{JB}$ ab. Um eine sichere Spannungsbegrenzung zu gewährleisten, muß die Bedingung $U_{BRCBO} < U_{BRCEO}$ eingehalten werden. Für die minimale $U_{CEO}$-Durchbruchsspannung $U_{BRCEO}$ gilt näherungsweise folgende Gleichung:

$$U_{BRCEO} = U_{BRCBO}^{EBEN}/(\beta + 1)^{(1/n)}.$$

Dabei wird mit β die Kleinsignalstromverstärkung des Transistors und n eine Konstante bezeichnet. Aus dieser Gleichung ergibt sich, daß $U_{BRCEO}$ umgekehrt proportional zu β ist, das heißt, es gilt:

$$U_{BRCEO} \ll U_{BRCBO}^{EBEN}$$

Durch die in Figur 2 dargestellten Spannungsbegrenzungszonen Z, die wenigstens einen Bereich mit einer im wesentlichen kreisförmigen Krümmung aufweisen, läßt sich eine weitere Reduzierung der Durchbruchs spannung bei abrupten pn-Übergängen erreichen. Je kleiner der Krümmungsradius R wird, um so geringer wird die Durchbruchsspannung $U_{BR}$. Wenn der Krümmungsradius etwa der Schichtdicke $x_{JB}$ entspricht, das heißt, für die Bezeichung $x_{JB} = R$, erreicht man den Grenzfall des sphärischen pn-Übergangs. Der Einfluß des Krümmungsradius' R auf die Verringerung der Durchbruchs spannung ist um so ausgeprägter, je abrupter, bzw. je sphärischer der pn-Übergang ist. Eine deutliche Beeinflussung der Durchbruchsspannung bei abrupten pn-Übergängen durch den Krümmungsradius R ist gegeben, wenn die Bedingung $R \leq W$ eingehalten wird, das heißt also, wenn der Krümmungsradius maximal so groß ist oder kleiner ist als die Weite W der Raumladungszone beim Durchbruch.

Die Zusammenhänge zwischen dem Krümmungsradius R und der Durchbruchsspannung $U_{BR}$ bei einem pn-Übergang werden in Figur 3 anhand eines Schaubilds dargestellt, bei dem die Durchbruchsspannung über dem Krümmungsradius aufgetragen ist. Dabei wurden die Bedingungen bei einer $n^-$-Diode vom Krümmungsradius R betrachtet, das heißt, in ein Substrat aus 60 Ohm/Zentimeter-$n^-$-Silizium werden kreisförmige p-Zonen mit verschiedenen Radien R eingebracht. Die Eindringtiefe $x_{JB}$ der mit Bor dotierten p-Schicht beträgt etwa 9μm. Aus der Darstellung ergibt sich die Abhängigkeit der Durchbruchsspannung $U_{BR}$ vom Krümmungsradius R. Die Durchbruchsspannung nimmt mit abnehmenden Krümmungsradius R ab. Für den Grenzfall des sphärischen pn-Übergangs nimmt R den Wert O an, das heißt, anstelle eines Kreises liegt ein rechter Winkel vor.

Überträgt man das Dotierungsprofil aus Figur 3 auf einen Basis-Kollektor-Übergang eines npn-Transistors, wobei dann $U_{BR}$ der Spannung $U_{BRCBO}$ entspricht, könnte durch einen geeigneten Emitter die minimale $U_{CBO}$-Durchbruchsspannung zum Beispiel 350V betragen. Man erhält dann für Krümmungsradien mit R < 50μm die gewünschte $U_{BCO}$-Spannungsbegrenzung.

Grundsätzlich kann mit einer einzigen Spannungsbegrenzungszone, das heißt, mit einer einzigen Stelle mit einem Krümmungsradius R im pn-Übergang bzw. im Randbereich der Basis 7 gegenüber dem Kollektor 1, eine Reduzierung der Sperrspannung erreicht werden. Allerdings treten dann in diesem Bereich bei einigen Anwendungsfällen relativ hohe Stromdichten auf, die zu einer starken Erwärmung des Bauelements führen, gegebenenfalls auch zu dessen Beschädigung. Außerdem ergibt sich eine weiche Durchbruchskennlinie, was für zahlreiche Anwendungsfälle unerwünscht ist.

Aus diesem Grund wird der pn-Übergang bzw. der Randbereich zwischen Basis 7 und Kollektor 5 mit zahlreichen gekrümmten Bereichen versehen, so daß mindestens eine Spannungsbegrenzungszone Z entsteht, wie dies in Figur 2 dargestellt ist.

Die genaue Ausgestaltung des Randbereichs ist noch einmal in den Figur 4 und 5 dargestellt. Eine der möglichen Ausgestaltungen einer Basisrandkontur ist in Figur 4 dargestellt. Sie besteht aus mehreren wechselseitig konkav und konvex ausgebildeten Bereichen, die unmittelbar aneinander angrenzen. Um eine wirksame Spannungsbegrenzung zu erzielen muß der Krümmungsradius R etwa der Weite W der Raumladungszone im Durchbruch entsprechen.

Ein weiteres Beispiel für die Ausgestaltung des pn-Übergangs bzw. des Randbereichs zwischen der Basis 7 und dem Kollektor 5 ist in Figur 5 dargestellt. Auch hier wird das Gebiet des Kollektors 5 vom Bereich der Basis 7 durch den Basisrand getrennt. Dieser besteht hier jedoch aus Halbkreisen mit dem Krümmungsradius R, die sich mit geraden Bereichen der Länge a abwechseln. Um eine optimale Spannungsbegrenzung zu erreichen, darf der Krümmungsradius R maximal der Weite W der Raumladungszone im Durchbruch entsprechen, so daß die Beziehung $R \leq W$ gilt und für a muß gelten, daß der gerade Bereich nicht kleiner ist als die doppelte Weite W der Raumladungszone im Durchbruch, so daß sich die Beziehung $a \geq 2W$ ergibt.

Grundsätzlich kann zur Erreichung der gewünschten Spannungsbegrenzung und zur Einstellung einer gewünschten Durchbruchskennlinie der pn-Übergang bzw. der Basisrandbereich beliebig ausgestaltet werden.

Bei den hier dargestellten Ausführungsbeispielen wird die Spannungsbegrenzung dadurch erreicht, daß Bereiche des Transistors selbst speziell ausgestaltet werden. Es zeigt sich, daß die Herstellung des Transistors an sich durch die Integration der Spannungsbegrenzungszonen unverändert bleibt. Das heißt, die Kosten der Herstellung ändern sich praktisch nicht. Es ist jedoch auch möglich, Schaltelemente mit mindestens einer Spannungsbegrenzungszone Z, wie Sie beispielsweise in den Figuren 4 und 5 dargestellt ist, dem Transistor zuzuordnen und getrennt von diesem auszubilden.

Aufgrund der integralen Realisierung des Spannungsbegrenzungsbereichs innerhalb des Halbleiters kann durch eine Schutzschicht über der Chipoberfläche auch der der Spannungsbegrenzung dienende Bereich vor äußeren Einflüssen geschützt werden. Die Spannungsbegrenzung wird auch nicht dadurch beeinträchtigt, wenn Bereiche mit verringertem Krümmungsradius mit einem Dielektrikum und/oder mit einer Metallschicht überdeckt sind.

Die hier vorgeschlagene Spannungsbegrenzung kann zur Erhöhung der Betriebssicherheit von Schaltungen mit regulären Spannungsbegrenzungseinrichtungen kombiniert werden.

Bei der hier vorgeschlagenen Spannungsbegrenzung ist sichergestellt, daß der $U_{CEO}$-Durchbruch senkrecht zur Oberfläche des Halbleiters praktisch unverändert bleibt. Dies liegt daran, daß die Spannungsbegrenzung allein durch die spezielle Ausgestaltung des Randbereichs des pn-Übergangs erzielt wird, das heißt, durch die Ausgestaltung des Randes der Basiswanne.

## Patentansprüche

1. Halbleiteranordnung, bei der in einen einkristallinen Halbleiterkörper (3) eines bestimmten Leitfähigkeitstyps von einer Hauptoberfläche her eine Verunreinigung derart eindiffundiert ist, daß im Halbleiterkörper (3) eine mit dem verbleibenden Halbleitermaterial (5) einen planaren pn-Übergang bildende Verunreinigungszone (7) vom entgegengesetzten Leitfähigkeitstyp gebildet wird, dadurch gekennzeichnet, daß die Schnittlinie des planaren pn-Übergangs mit der genannten Hauptoberfläche des Halbleiterkörpers (3) mindestens eine Spannungsbegrenzungszone (Z) mit einer Vielzahl von nebeneinander liegenden Bereichen aufweist, in denen die Schnittlinie unter einem vorbestimmten Krümmungsradius (R) verläuft, der kleiner oder gleich der Tiefe ($x_{JB}$) der Verunreinigungszone (7) ist.

2. Anordnung nach Anspruch 1, dadurch gekennzeichnet, daß die nebeneinander liegenden Bereiche abwechselnd konkav und konvex gewölbt und vorzugsweise jeweils halbkreisförmig ausgebildet sind.

3. Anordnung nach Anspruch 1, dadurch gekennzeichnet, daß die nebeneinander liegenden Bereiche durch gerade Abschnitte verbunden sind.

4. Anordnung nach Anspruch 3, dadurch gekennzeichnet, daß die Länge (a) der geraden Abschnitte etwa die doppelte Weite (W) der Raumladungszone im Durchbruch ausmacht oder größer als die doppelte Weite (W) ist.

5. Anordnung nach einem der Ansprüche 1 bis 4, dadurch gekennzeichnet, daß die Schnittlinie des planaren pn-Übergangs mit der genannten Hauptoberfläche des Halbleiterkörpers (3) im wesentlichen die Form eines Rechtecks aufweist, dessen Längs- und Querseiten je mindestens eine der mindestens einen Spannungsbegrenzungszonen aufweisen.

6. Anordnung nach einem der Ansprüche 1 bis 4, dadurch gekennzeichnet, daß die Schnittlinie des planaren pn-Übergangs mit der genannten Hauptoberfläche des Halbleiterkörpers (3) im wesentlichen die Form eines Kreises aufweist.

7. Anordnung nach einem der Ansprüche 1 bis 6, dadurch gekennzeichnet, daß der Krümmungsradius (R) der nebeneinander liegenden Bereiche gleich der Weite (W) der Raumladungszone beim Durchbruch oder kleiner als diese Weite (W) ist.

## Claims

1. Semiconductor arrangement, in which an impurity is diffused into a monocrystalline semiconductor body (3) of a specific conductivity type, from a main surface, in such a way that an impurity zone (7) of the opposite conductivity type is formed in the semiconductor body (3), which impurity zone forms a planar pn junction with the remaining semiconductor material (5), characterized in that the line of intersection of the planar pn junction with the said main surface of the semiconductor body (3) has at least one voltage-limiting zone (Z) having a multiplicity of regions which are situated next to one another and in which the line of intersection runs at a predetermined radius of curvature (R) which is less than or equal to the depth ($x_{JB}$) of the impurity zone (7).

2. Arrangement according to Claim 1, characterized in that the regions situated next to one another are designed to have alternate concave and convex cambers, and are preferably of semicircular design in each case.

3. Arrangement according to Claim 1, characterized in that the regions situated next to one another are connected by straight sections.

4. Arrangement according to Claim 3, characterized in that the length (a) of the straight sections amounts, for instance, to twice the width (W) of the space charge zone during breakdown or is greater than twice the width (W).

5. Arrangement according to one of Claims 1 to 4, characterized in that the line of intersection of the planar pn junction with the said main surface of the semiconductor body (3) essentially has the shape of a rectangle, the longitudinal and transverse sides of which each have at least one of the at least one voltage-limiting zones.

6. Arrangement according to one of Claims 1 to 4, characterized in that the line of intersection of the planar pn junction with the said main surface of the semiconductor body (3) essentially has the shape of a circle.

7. Arrangement according to one of Claims 1 to 6, characterized in that the radius of curvature (R) of the regions situated next to one another is equal to the width (W) of the space charge zone during breakdown or is less than this width (W).

## Revendications

1. Dispositif semi-conducteur selon lequel, dans un semi-conducteur (3) monocristallin d'un certain type de conductivité, on a diffusé une impureté à partir de sa surface principale, de façon à former dans le corps semi-conducteur (3), une zone d'impureté (7) formant une jonction pn planar avec le matériau semi-conducteur (5) restant, et de type de conductivité opposé, caractérisé en ce que la ligne de coupe de la jonction pn planar et la surface supérieure du corps semi-conducteur (3) comportent au moins une zone de limitation de tension (Z) composée d'un grand nombre de zones juxtaposées dans lesquelles la ligne de coupe correspond à un rayon de courbure (R) prédéterminé inférieur ou égal à la profondeur ($x_{JB}$) de la zone d'impureté (7).

2. Dispositif semi-conducteur selon la revendication 1, caractérisé en ce que les zones juxtaposées ont une courbure concave et convexe alternées et sont de préférence chaque fois en demi-cercle.

3. Dispositif selon la revendication 1, caractérisé en ce que les zones juxtaposées sont formées par des segments droits.

4. Dispositif semi-conducteur selon la revendication 3, caractérisé en ce que la longueur (a) des segments droits correspond sensiblement au double de la largeur (W) de la zone de charge limite en claquage, ou est supérieure au double de cette largeur (W).

5. Dispositif semi-conducteur selon l'une des revendications 1 à 4, caractérisé en ce que la ligne de coupe de la jonction pn planar et de la surface principale du corps semi-conducteur (3), correspond principalement à une forme de rectangle dont le grand et le petit côtés comportent chacun au moins une zone de limitation de tension.

6. Dispositif semi-conducteur selon l'une des revendications 1 à 4, caractérisé en ce que la ligne de coupe de la jonction pn planar et de la surface supérieure du corps semi-conducteur (3) présente en principe la forme d'un cercle.

7. Dispositif semi-conducteur selon l'une quelconque des revendications 1 à 6, caractérisé en ce que le rayon de courbure (R) des zones adjacentes est égal à la largeur (W) de la zone de charge limite en claquage, ou est inférieur à cette largeur (W).

Fig.1

$x_{JB}$

EP 0 556 201 B1

EP 0 556 201 B1

## Fig.2

8

Fig. 3

Fig.4

Fig.5